# EUROPÄISCHE PATENTANMELDUNG

(11) **EP 1 170 805 A2**
(43) Veröffentlichungstag der Anmeldung: **09.01.2002**
(21) Anmeldenummer: 01112763.6
(22) Anmeldetag: 26.05.2001
(51) Int. Cl.: H01L 31/042, H01L 31/048

(54) **Mit Solarzellen versehene Sanitärinstallation**

(30) Priorität: 04.07.2000 DE 10032463
(71) Anmelder: HANSA METALLWERKE AG, 70567 Stuttgart (DE)
(72) Erfinder: Kunkel, Horst, 70199 Stuttgart (DE)
(74) Vertreter: Ostertag, Ulrich, Dr.

(57) **Zusammenfassung**

Eine Sanitärinstallation (1) weist eine Sanitärarmatur (2) mit einer elektrisch betätigbaren Einrichtung, insbesondere einem Magnetventil auf. Weiterhin umfaßt sie eine wiederaufladbare Batterie (3), die von einer Solarzelleneinrichtung (6) gespeist wird, die Teil einer Versorgungseinrichtung ist. Die Solarzelleneinrichtung (6) ist in einem in der Nähe der Sanitärarmatur (2) befindlichen Spiegel (7) integriert. Umgebungslicht, das beim Betrieb der sanitären Vorrichtung regelmäßig vorliegt, reicht zum autarken Betrieb der Sanitärinstallation (1) aus.

## Beschreibung

Die Erfindung betrifft eine Sanitärinstallation mit einer Sanitärarmatur, mindestens einer elektrisch betätigbaren Einrichtung, insbesondere einem Magnetventil, einer wiederaufladbaren Batterie, einer eine Solarzelleneinrichtung umfassenden Versorgungseinrichtung für die Batterie und einem in der Nähe der Sanitärarmatur befindlichen Spiegel.

Bei bekannten derartigen Sanitärinstallationen ist die Solarzelleneinrichtung am Gehäuse der Sanitärarmatur untergebracht. Die Solarzelleneinrichtung ist dort nicht zum sicheren Betrieb z.B. eines Magnetventils geeignet, da zum Laden der Batterie nur ein sehr geringer Speisestrom abgegeben wird und daher die in der Batterie gespeicherte Energie sehr begrenzt ist.

Bekannte derartige Sanitärinstallationen müssen daher immer noch an ein Hausversorgungsnetz angeschlossen werden. Dies erfordert das Vorhandensein eines entsprechenden Netzanschlusses im Sanitärbereich, was nicht immer gewährleistet ist. Außerdem fallen beim Betrieb einer derartigen bekannten Sanitärarmatur Energiekosten an.

Es ist daher die Aufgabe der vorliegenden Erfindung, eine Sanitärinstallation der eingangs genannten Art derart weiterzubilden, daß ein sicherer Betrieb unabhängig von einem Hausversorgungsnetz gewährleistet ist.

Diese Aufgabe wird erfindungsgemäß dadurch gelöst, daß die Solarzelleneinrichtung in den Spiegel integriert ist.

Die Erfindung macht davon Gebrauch, daß in einem einen Spiegel aufweisenden Raum immer auch eine Lichtquelle (Tageslicht und/oder künstliches Licht) vorhanden sein muß. Ein kleiner Teil des von dieser Lichtquelle in Richtung des Spiegels emittierten Lichts wird mittels der Solarzelleneinrichtung zum Betrieb der Sanitärarmatur und/ oder zum Laden der Batterie eingesetzt.

Die von einer derart dimensionierten Solarzelleneinrichtung aufgeladene Batterie stellt ausreichend Energie zur Betätigung der Sanitärinstallation im normalen Gebrauch zur Verfügung. Die Größe der aktiven Fläche der Solarzelleneinrichtung gewährleistet dabei, daß die Batterie nachgeladen wird. Dazu reicht normales Umgebungslicht aus. Ein direkter Sonnenlichteinfall oder Tageslicht sind nicht erforderlich; wegen der großen einsetzbaren Fläche für die Solarzelleneinrichtung und dem in der Regel geringen Energiebedarf der Sanitärarmatur ist z.B. auch eine künstliche Beleuchtung des Sanitärbereichs ausreichend.

Dies ist bei anderen Konzepten zum Laden der Batterie, z.B. durch Ausnutzen des Wasserflusses in der Sanitärarmatur, nicht gegeben: Bei vollständig entladener Batterie ist eine Benutzung einer derartigen bekannten Sanitärarmatur mit einer auf den Wasserdurchfluß gestützten elektrischen Versorgung nicht mehr möglich, da schon die Energie zum Öffnen des Magnetventils nicht bereitsteht.

Auch eine Ladeeinrichtung der Batterie, die über Peltier-Elemente die Temperatur des Warmwassers zur Energieerzeugung ausnutzt, hat diese Nachteile, da sie ebenfalls vom Betrieb der Sanitärarmatur abhängig ist.

Der Spiegel kann ein Rahmengehäuse umfassen, wobei die Solarzelleneinrichtung in das Rahmengehäuse integriert ist. Bei einer derartigen Ausführung kann eine voll-reflektierende handelsübliche Spiegelfläche eingesetzt werden.

Alternativ kann der Spiegel eine teilreflektierende Schicht umfassen, wobei die Solarzelleneinrichtung hinter der teilreflektierenden Schicht angeordnet ist. Derartige teilreflektierende Spiegel sind einfach herstellbar. Auf diese Weise sind auch rahmenlose Spiegelausführungen möglich. Da Spiegel in der Regel eine relativ große Fläche einnehmen, muß nur ein relativ geringer Teil des auf die Spiegelfläche treffenden Lichts zur Energiegewinnung durch die Solarzelleneinrichtung durchgelassen werden. Der Großteil des auf die Spiegelfläche treffenden Lichts steht daher als reflektiertes Licht zur Verfügung.

Bevorzugt ist eine Versorgungsleitung, die die Batterie mit der Sanitärarmatur verbindet, in einem Rahmengehäuse geführt, das den Spiegel mit der Sanitärarmatur bzw. einem Waschtisch der Sanitärarmatur verbindet. Dies gestattet auf einfache Weise eine optisch ansprechende Ausgestaltung der Sanitärinstallation ohne störende sichtbare Kabel.

Die Solarzelleneinrichtung kann eine Mehrzahl von Solarzellenmodulen umfassen. Als Solarzellenmodul wird hierbei eine Standard-Baugruppe mit einer Solarzelle oder mehreren Solarzellen verstanden. Die Solarzellenmodule sind so ausgeführt, daß sie in einer Reihe verschiedener Relativpositionen miteinander elektrisch verbunden werden können. Auf diese Weise kann eine Solarzelleneinrichtung beliebiger Größe und Form aufgebaut werden. Verschiedene Spiegel und/ oder Rahmengrößen lassen sich daher bei Verwendung derartiger Solarzellenmodule mit der Solarzelleneinrichtung ausstatten.

Ausführungsbeispiele der Erfindung werden nachfolgend anhand der Zeichnung näher erläutert; es zeigen:
- Figur 1: schematisch eine Sanitärinstallation mit einer elektrisch betriebenen Sanitärarmatur und einem in einem Spiegel angebrachten Solarzellenmodul;
- Figur 2: einen Schnitt gemäß Linie II-II in Figur 1;
- Figur 3: einen Spiegel einer alternativen sanitären Vorrichtung, bei dem vier Solarzellenmodule im Rahmengehäuse untergebracht sind; und
- Figur 4: einen Schnitt gemäß Linie IV-IV in Figur 3.

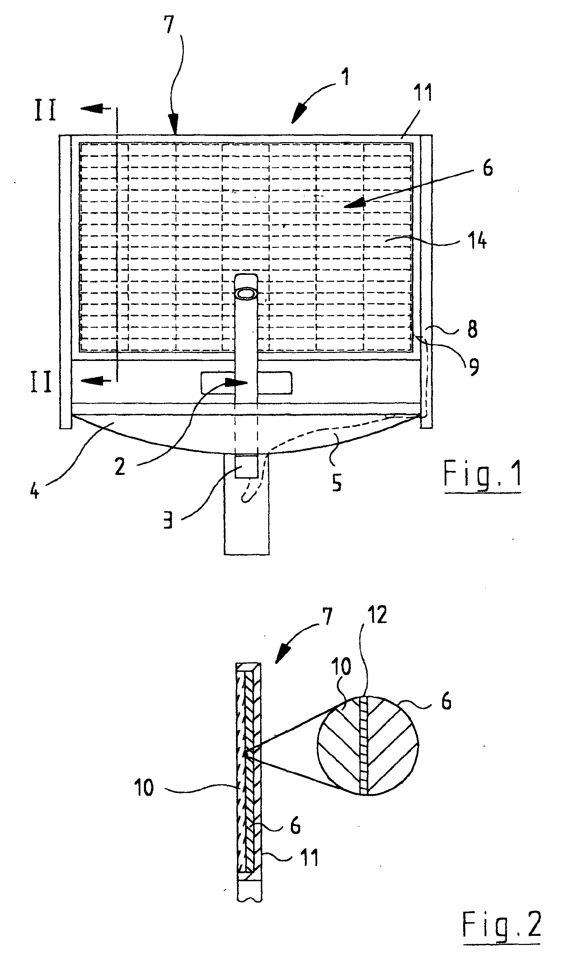

Eine in Figur 1 insgesamt mit dem Bezugszeichen 1 bezeichnete Sanitärinstallation umfaßt eine berührungslos gesteuerte Sanitärarmatur 2. Zur elektrischen Versorgung, z. B. eines (nicht dargestellten) Näherungssensors der Sanitärarmatur 2 und von den Wasserfluß steuernden Magnetventilen dient eine in deren Gehäuse untergebrachte wiederaufladbare Batterie 3. Die Sanitärarmatur 2 wird von einem Waschtisch 4 getragen.

Zum Laden der Batterie 3 weist diese eine elektrische Versorgungsleitung 5 auf, die, da sie in der Ansicht der Figur 1 nicht sichtbar ist, gestrichelt dargestellt ist. Die Versorgungsleitung 5 verbindet die Batterie 3 mit einem Solarzellenmodul 6, das in einem zur Sanitärinstallation 1 gehörenden Spiegel 7 untergebracht ist.

Ausgehend von der Batterie 3 ist die Versorgungsleitung 5 zunächst hinter dem Waschtisch 4 und dann in einem Rahmengehäuse 8 des Spiegels 7 verlegt. Das Rahmengehäuse 8 erstreckt sich zu beiden Seiten des rechteckigen Spiegels 7 nach unten und kommt dabei mit seitlichen Stirnflächen des Waschtischs 4 in Anlage. In diesem Bereich ist die Versorgungsleitung 5 von außen nicht sichtbar ins Innere des in Figur 1 rechten Abschnitts des Rahmengehäuses 8 geführt und verläuft in diesem bis zu einem elektrischen Anschluß 9, der die Versorgungsleitung 5 mit dem Solarzellenmodul 6 verbindet.

Das Solarzellenmodul 6 besteht aus einer Vielzahl von Solarzellen, die in Figur 1 als gestrichelte Rechtecke angedeutet und miteinander elektrisch verschaltet sind.

Den Aufbau des Spiegels 7 verdeutlicht die Schnittdarstellung der Figur 2:

Eine rückseitig teilreflektierend beschichtete, rechteckige Glasscheibe 10 ist in ein Rahmengehäuse 11 eingesetzt. Die teilreflektierende Schicht wird von einer aufgedampften Metallschicht 12 gebildet, die in der Ausschnittsvergrößerung von Figur 2 schematisch dargestellt ist. Ebenfalls in das Rahmengehäuse 11 eingesetzt ist das hinter der Glasscheibe 10 und der von dieser getragenen Metallschicht 12 angeordnete Solarzellenmodul 6.

Die Sanitärinstallation 1 funktioniert folgendermaßen:

Die zur Betätigung der Sanitärarmatur 2 erforderliche elektrische Energie wird von der Batterie 3 bereitgestellt. Letztere wird über das Solarzellenmodul 6 und die Versorgungsleitung 5 nachgeladen. Dies erfolgt immer dann, wenn verwertbares Licht, d. h. entweder Tageslicht oder künstliches Beleuchtungslicht auf den Spiegel 7 fällt. Dieses Licht wird nur teilweise von der Metallschicht 12 der Glasscheibe 10 reflektiert. Der restliche Anteil wird von der Metallschicht 12 durchgelassen und gelangt so zum Solarzellenmodul 6, in welchem es in elektrische Energie umgewandelt wird. Bei beleuchtetem Spiegel 7 steht somit elektrische Energie zur Verfügung, die zum Betrieb der Sanitärarmatur 2 genutzt werden kann.

Statt einer rückseitigen Metallschicht 12 kann alternativ auch eine frontseitige teilreflektierende Beschichtung der Glasscheibe 10 vorliegen. Bei einer weiteren Variante kann die Glasscheibe 10 ganz weggelassen sein und die Metallschicht 12 kann direkt auf dem Solarzellenmodul 6 aufgetragen sein.

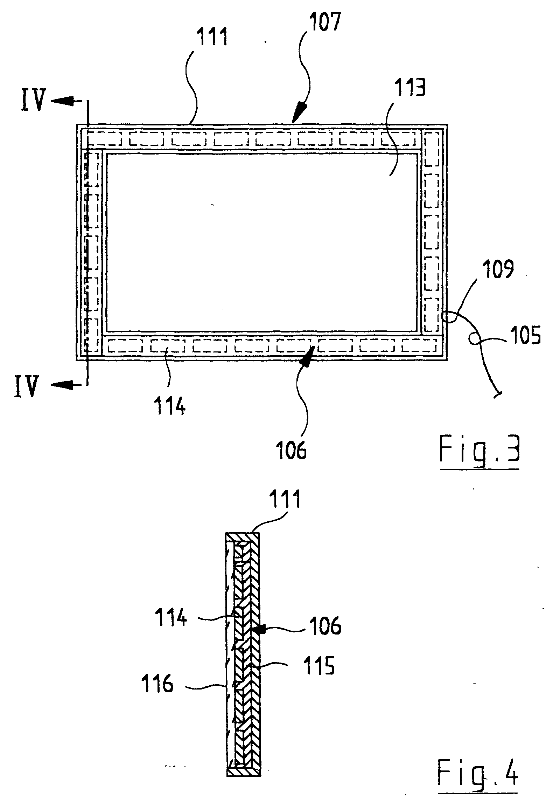

Eine alternative Ausführungsform einer Sanitärinstallation ist in den Figuren 3 und 4 dargestellt. Komponenten, die denjenigen entsprechen, die in Zusammenhang mit den Figuren 1 und 2 beschrieben wurden, tragen mit um 100 erhöhte Bezugszeichen und werden nicht nochmals im einzelnen erläutert.

Der Spiegel 107 der alternativen Sanitärinstallation der Figuren 3 und 4 weist eine zentrale, vollverspiegelte Spiegelfläche 113 auf, die von einem rechteckigen Rahmengehäuse 111 umgeben ist. In das Rahmengehäuse 111 sind bei dieser Ausführungsform vier Solarzellenmodule 106 eingesetzt. Die beiden in die Längsseiten des Rahmengehäuses 111 eingesetzten Solarzellenmodule 106 weisen jeweils acht als gestrichelte Rechtecke dargestellte Solarzellen 114 auf und die in den Schmalseiten des Spiegelgehäuses 111 untergebrachten Solarzellenmodule 106 jeweils deren fünf. Die Solarzellen 114 der Solarzellenmodule 106 stehen auf nicht dargestellte Weise elektrisch miteinander in Verbindung. Durch im Detail nicht dargestellte elektrische Steckverbindungen sind die vier Solarzellenmodule 106 elektrisch miteinander verbunden.

Figur 4 zeigt, daß die Solarzellen 114 in ein Modulgehäuse 115 eingesetzt sind, das mit einer die aktiven Flächen der Solarzelleneinheiten 114 abdeckenden Abdeckscheibe 116 aus Glas in das Rahmengehäuse 111 eingesetzt ist. Die Abdeckscheibe 116 ist unverspiegelt.

Über einen Anschluß 109 stehen die Solarzellenmodule 106 mit einer Versorgungsleitung 105 in Verbindung.

Der über den Spiegel 107 hinausgehende Aufbau der Sanitärinstallation der Figuren 3 und 4 entspricht demjenigen, der in den Figuren 1 und 2 dargestellt ist.

Bei der Sanitärinstallation gemäß den Figuren 3 und 4 wird dasjenige Licht, welches auf das die Spiegelfläche 113 umgebende Rahmengehäuse 111 trifft, zur Umwandlung in elektrische Energie genutzt. Diese in den Solarzellenmodulen 106 erzeugte elektrische Energie wird über die Versorgungsleitung 105 an die Batterie der Sanitärarmatur weitergeleitet.

## Patentansprüche

1. Sanitärinstallation mit einer Sanitärarmatur, mindestens
einer elektrisch betätigbaren Einrichtung, insbesondere einem Magnetventil, einer wiederaufladbaren Batterie, einer eine Solarzelleneinrichtung umfassenden Versorgungseinrichtung für die Batterie und einem in der Nähe der Sanitärarmatur befindlichen Spiegel,
**dadurch gekennzeichnet, daß**
die Solarzelleneinrichtung (6; 106) in den Spiegel (7; 107) integriert ist.

2. Sanitärinstallation nach Anspruch 1, **dadurch gekennzeichnet, daß** der Spiegel (107) ein Rahmengehäuse (111) umfaßt, wobei die Solarzelleneinrichtung (106) in das Rahmengehäuse (111) integriert ist.

3. Sanitärinstallation nach Anspruch 1, **dadurch gekennzeichnet, daß** der Spiegel (7) eine teilreflektierende Schicht (12) umfaßt, wobei die Solarzelleneinrichtung (6) hinter der teilreflektierenden Schicht (12) angeordnet ist.

4. Sanitärinstallation nach einem der vorhergehenden Ansprüche, **dadurch gekennzeichnet, daß** eine Versorgungsleitung (5; 105), die die Batterie (2) mit der Sanitärarmatur (2) verbindet, in einem Rahmengehäuse (8) geführt ist, das den Spiegel (7) mit der Sanitärarmatur (2) bzw. einem Waschtisch (4) der Sanitärarmatur (2) verbindet.

5. Sanitärinstallation nach einem der vorhergehenden Ansprüche, **dadurch gekennzeichnet, daß** die Solarzelleneinrichtung (106) eine Mehrzahl von Solarzellenmodulen (106) aufweist.
